# EUROPEAN PATENT SPECIFICATION

(11) **EP 1 318 211 B1**
(45) Date of publication and mention of the grant of the patent: **27.08.2008**
(21) Application number: 01129129.1
(22) Date of filing: 07.12.2001
(51) Int. Cl.: C23C 16/52, C23C 16/44, G01B 11/06, H01J 37/32

(54) **Arrangement for monitoring a thickness of a layer depositing on a sidewall of a processing chamber**
Anordnung zur Überwachung der Dicke einer Schicht, die an der Innenseite einer Prozesskammer abgeschieden wird
Système de surveillance de l'épaisseur d'une couche se déposant sur les parois d'une chambre de traitement

(43) Date of publication of application: 11.06.2003
(73) Proprietor: Infineon Technologies SC300 GmbH & Co. KG, 01099 Dresden (DE)
(72) Inventor: Tegeder, Volker, 01474 Weissig (DE)
(74) Representative: Epping - Hermann - Fischer

(56) References cited:
- EP-A- 0 644 574
- WO-A-01/00900
- US-A- 6 025 916

## Description

The present invention relates to an apparatus for monitoring a thickness of a layer depositing on a sidewall of a processing chamber.

In semiconductor device manufacturing many processing steps involve a removal or deposition of layer material on the surfaces of the semiconductor devices in a processing chamber. Examples are the processing steps of plasma etching or plasma chemical vapour deposition (PCVD). While performing such processing steps, it often occurs unintendedly that reaction products or polymer material physically removed from the device surface deposit on the side walls of the processing chamber. In the case of plasma etching, e.g. reactive ion etching (RIE), reactive ion beam etching (RIBE) or chemically assisted reactive ion beam etching (CAIBE), hot reaction products may condense in a low-pressure environment on the comparatively cold plasma chamber sidewalls. Etching is also often performed on semiconductor devices being covered with a resist mask on its surface comprising a polymer composition leading to a deposition of polymer layers on the sidewalls.

With continuing utilization of the processing chamber, the thickness of the deposited layer grows, and when a characteristic thickness value depending on the layer composition is exceeded, a process called flaking occurs within this layer. The relatively smooth surface structure hitherto existing on the growing layer breaks up leading to a rough surface structure. Occasionally, pieces of this layer lose support, split off and may disadvantageously fall and stick onto the device surface, which is currently being manufactured. In the case of a semiconductor wafer parts of integrated circuits might be destroyed. In order to anticipate flaking events, one typically performs wet cleaning or other cleaning steps on that processing chamber, during which unfortunately production has to be discontinued.

The exact choice of time for starting the cleaning step generally depends on operation experience. Typically, a wet clean is performed, and by investigating e.g. consumable parts removed from the processing chamber the layer thickness of e.g. polymers deposited on the part can be inspected by means of dedicated measurement tools. Also the surface structure can be investigated to determine a posteriori, whether there would have been sufficient time to continue production before cleaning the sidewalls, or whether it is already too late, i.e. flaking has already started. Another approach is to perform particle tests or statistics on test production devices. In any case, a loss in production efficiency is involved when performing cleaning steps of processing chambers just by experience and/or exterior measurements.

It has also been proposed to measure deposition thicknesses by means of heat capacity or ultrasonic wave runtime measurements. While these approaches provide in-situ and online measurements, the corresponding measurement arrangements are complicated due to the necessity of leading electrical conductors through wall openings in the sidewall of the processing chamber. Moreover, runtime measurements are sensitive to temperature changes, and are also prone to being affected by irritating reflections due to the consumable parts inside the processing chamber.

In WO 01/00900 A1 an arrangement for monitoring the change of deposition layer thicknesses in processing chambers is provided, which uses a sensor having a transparent or at least semi-transparent orifices, through which a light beam originating from a light source is transmitted to a detector for measuring the light intensity. The sensor is placed inside the processing chamber and is prone to layer deposition. The intensity of light traversing the orifice decreases due to absorption of the layer growing on and inside the orifice. From geometrical considerations of e.g. a homogeneously depositing material, it is clear that the diameter of the orifice shrinks. Once a relation between light intensity and layer thickness has been established, an efficient monitoring is possible, while just the conventionally existing process chamber windows can be used to interfere with the inner space of the processing chamber using just a light beam.

US 6 025 916 A discloses a device for measuring polymer build-up on plasma chamber walls comprising a cooled window on which a film forms. By interferometric techniques a light beam passing through the window is used to determine changes in film thickness.

It is a primary objective of the present invention to provide an arrangement and a method for monitoring the thickness of a layer depositing on sidewalls of processing chambers, which enhances the productive time between two adjacent wet clean steps while retaining or increasing the manufacturing quality of a processing chamber with least effort spent in costs and material.

Moreover it is an objective to provide an arrangement, which enables the use of existing etching or deposition tools together with the present arrangement, thereby reducing the necessity of adapting the chamber construction to the arrangement requirements, in particular the number, size and position of chamber windows.

The objective is solved by an apparatus according to claim 1 and a method according to claim 24.

Using a method for monitoring a layer deposition on a sidewall of a plasma chamber utilizing such an apparatus, a light beam is irradiated onto said sensor surface using said light source, the intensity of light being emitted or reflected by said surface using said detector is measured, the value of measured intensity is compared with a threshold value representing a critical thickness value of a layer on the sidewall using the control unit, and a signal is issued in response to that comparison.

In particular, the measured intensity is interpreted in terms of absorption which is related to the layer thickness, or (not according to the invention) in terms of interference of light reflected from the mirror surface and that reflected from the surface of the layer deposited on the sensor mirror surface, which is also related to the actual thickness of said layer.

The preferred embodiments are subject of the dependent claims.

The thickness of a depositing film layer on a processing chamber sidewall is determined by a transmission or reflectivity measurement of a light beam through the corresponding film layer depositing on a sensor. The sensor preferably is placed in the local vicinity of the sidewall to be inspected inside the processing chamber. By means of a light beam, the light source has an access path to that sensor. Said sensor either directly reflects the light by means of a mirror layer, which may be the surface or any underlying layer (not according to the invention), or receives the light beam, converts it followed by re-emitting the light into one or more directions.

The light source can be a laser or any other multi-wavelength light source. It is also possible that the wavelength can be changed online by means of optical filters or similar means. The optical light path from the light source to the sensor may comprise mirrors for re-directing the light towards the sensor. The light source is placed preferably outside the processing chamber and has access to the sensor through a window.

A placement inside the processing chamber is particularly possible in the advantageous case of the processing chamber being a plasma chamber and the plasma light serving as the light source so that there is generally no restriction of the light source placement according to the present invention.

The film layer growing on the sensor surface by means of absorption has the effect of absorbing light intensity before the light beam intersects the sensor surface. After reflection or re-emitting the light the amount of intensity is once more absorbed by the film layer. In the case of reflection from a mirror layer of the sensor, the angle of incidence of the incident light beam and the exiting angle of the exiting light beam are typically the same, thereby defining the relative placement of light source, sensor and detector. There is also a direct optical path between the sensor and the detector, which may also comprise re-directing mirrors. Preferably, the detectors are mounted outside the processing chamber, but a placement inside is not excluded.

The main advantage of the present invention is that a relation between layer thickness and light intensity can be established either theoretically or by experiments, which can then serve as the basis for online thickness measurements.

A control unit is connected to the detector in order to determine the actual thickness of the deposited film layer from the light intensity measurement. Preferably by means of previous experiments, the thickness of the sidewall layer can be derived by the control unit from the determined thickness of the deposited film layer on the sensor. This is because the deposition rate can vary considerably inside the processing chamber from position to position and from surface material structure to a next. Thus, gauging can be performed by measuring and comparing layer thicknesses on the sensor substrate and the sidewall after an amount of utilisation time of the processing chamber. Preferably, this procedure is repeated for a set of utilisation times in order to regard a nonlinear relation.

The detector can be any photosensitive device that is able to receive and detect optical wavelength as well as infrared light or ultraviolet light. It is considered that it comprises optical means for providing a position-dependent resolution, i.e. a picture of the sensor surface in order to detect gradients of film layer depositions. This may be provided by a CCD-camera or a photo diode.

If, for example a sensor surface being free of a deposited layer, i.e. at an initial state or after having experienced a cleaning step, the intensity of reflected or re-emitted light is substantially equal to the incident beam intensity. Then the intensity of the re-emitted or reflected light decreases monotonically with growing layer thickness until flaking starts. Thus online measurement of light intensity using the detector provides a means for determining the amount of time that can be used to continue semiconductor device processing using the common processing chamber set-up. When such a time event is reached, i.e. flaking starts, in this example defining the minimum light intensity point, a sudden light intensity change occurs indicating that flaking has already started. Using the control unit this time event can be pre-determined. A signal can be issued either indicating the time left for processing, or warning the operator to start the onset of a cleaning step, i.e. wet clean.

To accomplish this, an exact measurement of intensity as a function of layer thickness can be carried out at the time of tool setup, e.g., such that when an actual measurement is made according to the present invention, the experience obtained from the previous setup-measurements can be used to determine the actual status.

What can actually be measured is a light intensity decrease due to absorption of the depositing film layer or (not according to the invention) interference of light reflected by the sensor mirror - layer interface and by the layer aurface. The difference of the reflected light beam and the re-emitted light derives from two distinct preferred embodiments:

The first is reflection due to a mirror layer that is separated from the sensor surface by means of a transparent layer protecting the mirror layer from the reactant gases in e.g. the plasma chamber. Thus, the light beam traverses the deposited film layer, the protection layer and is then reflected by the mirror layer, which for example can be composed of a metal deposited on a silicon layer or the silicon layer itself. Afterwards, it traverses once more each the protection layer and the deposited film layer before it reaches the detector.

The second aspect of re-emission according to the invention considers the light-beam to activate a fluorescence layer beneath, e.g. the protection layer at a first wavelength, while the fluorescence layer re-emits light at a second wavelength. This feature can be utilised in that the wavelength of the incident light beam is chosen such that it is not absorbed significantly by the deposited film layer, and the intensity is chosen such as to reach the saturation regime of the fluorescence layer, thereby being independent from the actual intensity losses of the incident beam before it reaches the fluorescence layer. Thus, with a range of not too high thickness values of the deposited film layer it can be assumed that the fluorescence layer emits light with constant intensity, which is then absorbed when traversing the deposited film layer from beneath. Generally, the re-emitted light from the fluorescence layer has diffuse directions leading to a weaker signal in the detector. The fluorescence material is chosen such that the re-emitted light wavelength experiences significant absorption due to the deposited film layer, in contrast to the incident beam.

The re-emitted light, or the reflected light, having a spectral distribution provides a further feature that a detector supplied with a spectral analysis means can additionally provide information about the depositing film layer chemical composition as well as physical information like temperature, or partical sizes, roughness. In this case, the detector is embodied as a spectrometer.

Further advantages and aspects are evident from the dependent claims.

The invention will be better understood by reference to embodiments taken in conjunction with the accompanying figures, where in
Figure 1 shows an apparatus with a laser beam directed upon a sensor inside a plasma etching chamber and a detector monitoring the intensity of reflected light with time,
Figure 2 shows an apparatus with two sensors placed at different positions inside the plasma chamber,
Figure 3 shows an apparatus, where the sensor can be moved along a guide rail in the chamber, and a mirror is rotated redirecting the laser beam onto the sensor,
Figure 4 shows a version of the sensor having a mirror layer for reflecting an incident light beam,
Figure 5 shows an embodiment of the sensor having a fluorescent layer,
Figure 6 shows an embodiment of the present invention with chopping the light beam under control of the control unit connected to the detector,
Figure 7 shows an embodiment with a movable aperture,
Figure 8 shows an embodiment of the sensor having four surface structures with different sensitivities to layer deposition.

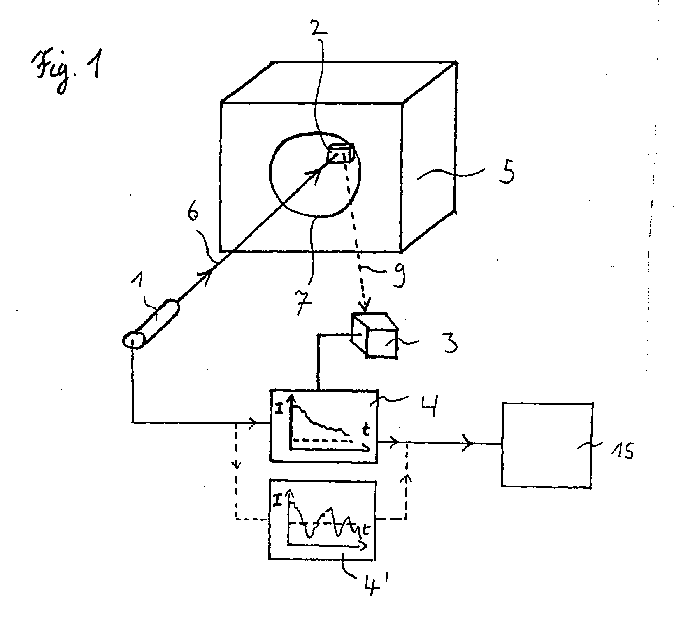

An arrangement comprising a laser 1 emitting a light beam 6 through a window 7 of plasma chamber 5 onto a sensor 2 is shown in figure 1. The plasma chamber 5 used in this arrangement is intended for etching semiconductor wafers. With ongoing use of the plasma chamber, i.e. etching, a film comprising e.g. polymers deposits on the sensor 2 surface. Before, during, or after etching - whenever the light beam is incident on that sensor 2 - the light beam 6 traverses the film layer 10 and is reflected by an underlying mirror layer. Once more the light beam traverses the film layer 10 and exits the plasma chamber 5 through the same window 7 and is collected by a detector 3. A control unit 4 is connected to the detector 3 and calculates the intensity from the detection signal. Control unit 4 is also connected to the laser light source 1 for having a reference intensity with which the detected intensity can be compared.

A threshold value for intensity as inferred from prior experiment is available, with which the current intensity being measured can be compared - after normalising it with the reference intensity. Due to absorption of the adsorbing material the intensity of the reflected light generally decreases such that the intensity curve as plotted versus time intersects with the constant threshold value line. In response to this event, the comparison results in a signal that is issued by the system, i.e. the control unit 4, which is then forwarded to e.g. the line control system or the manufacturing execution system warning or informing the operator that a step of wet clean is due.

In a refined version, the control unit 4 calculates from the slope of the measured intensity as a function of time a time value, where the intersection of the measured curve with the threshold value presumably will occur. This option provides operators more freedom when scheduling and planning forthcoming production.

As can also be seen from figure 1, an alternatively working control unit 4' interprets the measured intensity as a function of time in terms of interference. With increasing layer thickness the light amplitudes reflected each from the layer surface and the mirror - deposited layer interface are added or subtracted to each other depending on their sign and depending on the wavelength of the incident light due to the different light path lengths. In this case, the intensity curve does not monotonically decrease, rather several maxima and minima can be recognized. The number of maxima or minima already run through in the present process setup show the current status. A threshold value, which is found by experience, can be given, and, e.g., an n-th crossover over a maximum or a threshold value indicates a critical layer thickness for the due onset of flaking and the necessary start of a wet clean step. Preferrably, monochromatic light is used for this embodiment. With this embodiment a time value for which the onset will occur in future can as well be calculated.

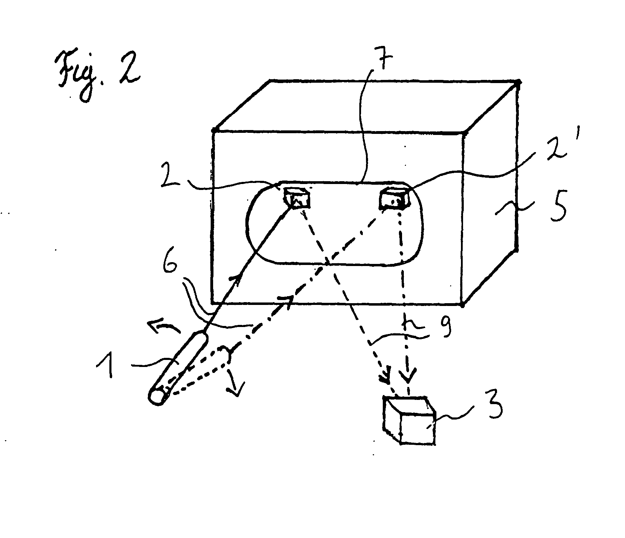

Another version of the arrangement is shown in figure 2. The laser is movable in the sense that two different sensors mounted inside the plasma chamber can be supplied with a light beam, which is arranged such that the reflected light beam meets the detector. In case of the reflection type of the present invention the requirement that incidence angle and exerting angle of the preferably plain sensor surface is regarded. The feature of moveability of the light source can be replaced by a movable mirror redirecting the light beam onto the two sensors through the plasma chamber window. Three aspects can be covered when employing two or more sensors:

A first of the two sensors is used for measuring the deposition layer 10 thickness, and thus is placed at a position inside the plasma chamber 5 suffering significantly from film deposition, while the second sensor 2' serves as a reference sensor providing a reference intensity, and therefore is placed at a position inside the plasma chamber 5 being substantially free of film layer deposition. The light source 1 supplies both sensors alternatingly with the light beam and the detector 3 and/or the control unit 4 not shown in this figure perform the intensity normalisation.
Both sensors 2, 2' are mounted at different places for monitoring a spatial distribution of layer deposition inside the plasma chamber 5.
Both sensors are arranged to provide different sensitivities for providing a thickness measurement covering different ranges of layer deposition strength. For example, if the deposition layer 10 becomes nearly opaque on the surface of sensor 2, the second sensor 2', which provides a less efficient layer deposition, still allows some amount of transparence, and therefore enables an advanced thickness measurement on this sensor. The sensitivity may also be controlled either by heating/cooling, or by providing a dedicated surface structure, e.g. roughness due to holes.

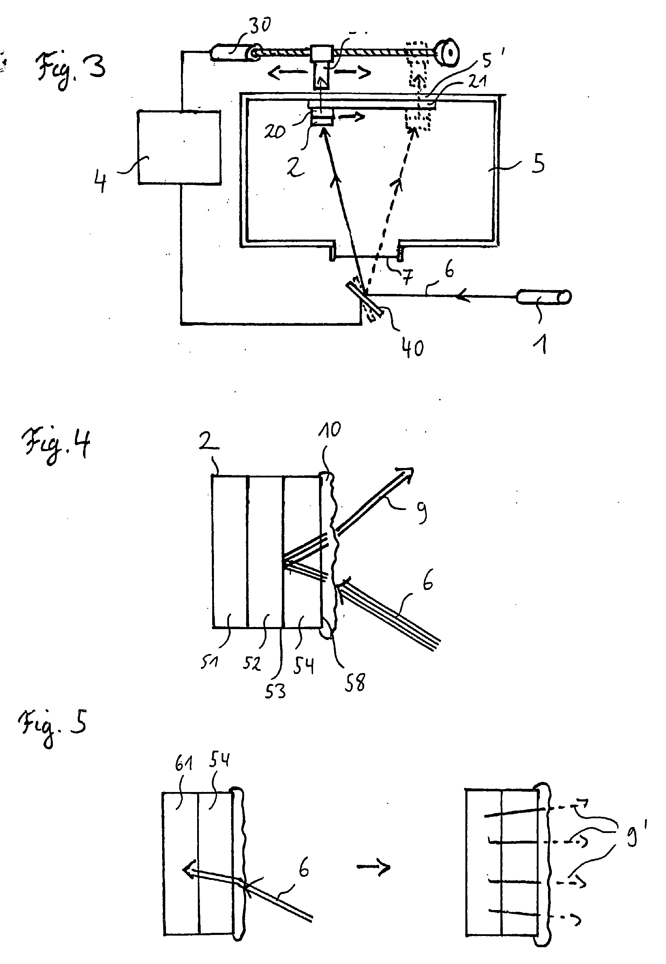

In a further embodiment, shown in figure 3, at least one sensor 2 inside the plasma chamber 5 is supplied with a magnetic means 20 mounted on a guide rail 21 along which it can be moved. That guide rail 21 is mounted at the plasma chamber wall 5'. Behind this plasma chamber wall 5' a motor 30 provides a movement of an exterial magnet 31 being magnetically coupled with the sensor magnet 20. Moving the exterior magnet 31 the sensor 2 is also moved and can be transferred to a position of interest in the plasma chamber 5.

The motor 30 is connected to the control unit 4, to which is also connected a rotatable mirror 40 for redirecting the laser beam 6 from the light source 1. By means of control unit 4 the movement of sensor 2 due motor 30 and the rotation of the rotatable mirror 40 can be synchronised in order to retain the beam on this servers area of sensor 2. A dedicated orientation mechanism of the sensor surface in order to supply the detector 3 not shown in figure 3 for clarity with emitted light 9 has also to be provided, then.

Using the embodiment shown in figure 3 special distribution of film layer 10 deposition can be monitored and problems easily be recognized. For impeding problems of film layer deposition on the window 7, that window is embodied as a recess window.

A sensor element 2 of the reflection type is shown in figure 4. The surface 58 of a transparent protection layer 54 comprising SiO₂ surface as the base for the slowly growing film deposition layer 10. The protection layer 54 has a contact surface with a non-transparent base layer 52 made of silicon, which serves as a mirror layer reflecting the incident beam traversing the film layer 10 and the SiO₂-layer, and is manufactured by metal deposition on the silicon surface. Such a sandwich sensor 2 can be controlled in its sensitivity by a means for cooling/heating 51 layer. In the case of a cooling layer 51 a material working by means of the Peltier-effect is provided to increase the condensation of depositing material on the surface 58. Electrically heating layer 51 on the other hand would decrease the amount of deposition per time.

In another refined embodiment sensor 2 comprises a set of structures on surface 58, to which can be applied different temperatures, e.g. a temperature gradient. The detector 3 is then enabled to screen such a gradient, which possibly emerges in different layer deposition strengths depending on the temperature. Such characteristics can be measured.

The sensor 2 according to the present invention is of the fluorescence type. As displayed in figure 5, the protection layer 54 covers a fluorescence layer 61 which is activated by light having adequate wavelength. The light beam intensity is strong enough to supply the fluorescence layer with a sufficient dose, such that light is re-emitted in the saturation regime of the fluorescence layer 61. Since in this case the re-emission intensity is known, the measurement of a reference intensity is not further needed. The fluorescence layer 61 than re-emits diffuse light 9', which is than collected by the detector 3. What is measured here is the intensity loss during just one traversal through the film layer 10.

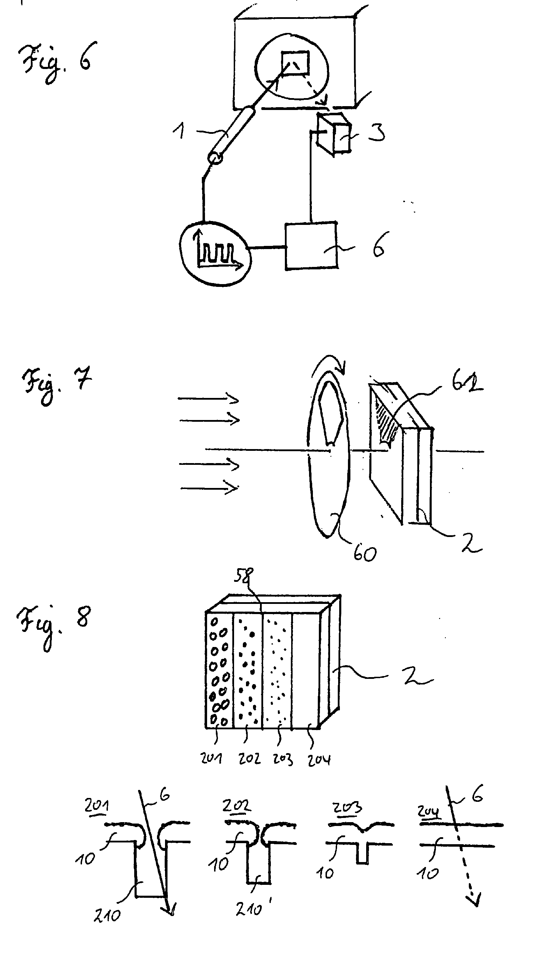

In order to increase this signal-to-noise ratio, the signal of the light source 1 can be choppered, which is synchronised with the light detection in detector 3. Correspondingly, control unit 4 performs the task of synchronising light source 1 and detector 3, which is shown in figure 6.

According to another embodiment the sensor 2 is provided with a movable aperture 60, due to which a surface portion 61 of the sensor 2 is exposed to gases and material inside the plasma chamber 5. As indicated in figure 7, a rotatable plate having an aperture is positioned in front of the surface 58 of sensor 2 being sufficiently near to the surface such as to protect the non-exposed surface areas of sensor 2. In figure 7, the distance is not shown to scale, rather it should be near enough, such that no contact with the surface is established yet.

Another embodiment of a sensor 2 is shown in figure 8. The sensor surface 58 comprises four different surface structures 201 to 204 each being supplied with holes or orifices of distinct size, depending on the area. For example, surface structure 201 having a dense grid of holes having the largest size provides a surface, that is least sensitive to film layer deposition, because - as shown in the bottom section of figure 8 - a larger orifice 210 needs an amount of time to be closed by the growing thickness of the deposition layer 10, which is larger than the time needed for the smaller orifices 210' of surface structure 202. Surface structure 204 comprises no or negligible holes, and therefore permits less amount of light to pass through the height range of the deposition layer 10, while the larger orifices allow more light to pass through. It is also possible to distribute a set of different sensors 2, 2' inside the plasma chamber 5 each having their own roughness each, or density of holes in the surface 58 of sensor 2.

It is also possible to construct a pattern on the sensor surface that is extremely insensitive to film layer deposition, and thus can solve as a reference sensor for a light beam. In comparison of two or more sensor surfaces having different sensitivities can than be made inside the chamber 5.

It has to be noted that the sensor surface 58 can be any material compatible with plasma processors. In the case of a protection layer, which is transparent or in the case of a reflecting mirror layer 53 these requirements must hold in order to impede the change of transmission or absorption characteristics of the surface.

In another embodiment a light detector is mounted inside the chamber integrated into the surface of the sensor to measure the intensity of the light.

### List of reference numerals

- 1: light source, laser
- 2: sensor
- 3: detector
- 4: control unit
- 5: plasma chamber
- 6: incident light beam
- 7: window of plasma chamber
- 9: reflected light beam
- 9': emitted light of fluorescence layer
- 10: deposited film layer
- 15: line control unit
- 20: sensor magnet
- 21: guide rail for sensor
- 30: motor for magnet
- 31: exterior magnet
- 40: rotatable mirror
- 51: cooling/heating layer
- 52: silicon layer
- 53: mirror layer (metal on silicon)
- 54: protection layer
- 58: sensor surface
- 60: movable aperture
- 61: fluorescence layer
- 62: surface structure exposed to plasma chamber gasses
- 201-204: surface structures with different amount of roughness
- 210: surface hole, orifice

## Claims

1. Apparatus for monitoring a thickness of a layer depositing on a sidewall of a processing chamber (5), comprising
- at least a first light source (1),
- a sensor (2) having a sensor surface (58), said sensor (2) being designed to affect, when being covered with a layer of a layer deposition material, the intensity of a light beam (6) which the sensor (2) receives and re-emits, said sensor (2) being placed inside said plasma chamber (5) and being different from said sidewall of said processing chamber (5),
- a detector (3) for detecting an intensity of light originating from said first light source (1),
- a control unit (4) being connected to said detector (3) for determining from said intensity measurement said thickness of said layer depositing on said sidewall,
- wherein said first light source (1), said sensor (2) and said detector (3) are arranged such that a light beam (6) can be directed onto said sensor surface (58) and light (9, 9') emitted by said sensor (2) can be received by said detector (3),
**characterized in**
- **that** said sensor (2) comprises at least one layer of fluorescence material (61),
- **that** said light beam (6) emitted by said first light source (1) comprises a first wavelength for which said layer deposition material is substantially transparent and
- **that** said light (9') being re-emitted by said fluorescence material (61) comprises a second wavelength for which said layer deposition material absorbs intensity.

2. Apparatus according to claim 1,
**characterize in that**
- said processing chamber (5) comprises an inner space,
- said detector (3) is positioned outside said inner space,
- said processing chamber (5) comprises a window (7), through which said light beam (6) can exit said processing chamber (5) towards said detector (3).

3. Apparatus according to claim 1,
**characterized in that**
- said processing chamber (5) comprises an inner space,
- said detector (3) is positioned inside said inner space.

4. Apparatus according to anyone of claims 1 - 3,
**characterized in that**
said sensor (2) comprises a protection layer (54) at the sensor surface (58) in order to be not affected by the deposition processing, said protection layer (54) being transparent for light emitted by said first light source (1).

5. Apparatus according to claim 4,
**characterized in that**
said protection layer (54) comprises silicon dioxide.

6. Apparatus according to anyone of claims 1 - 5,
**characterized in that**
said sensor (2) comprises a mirror layer (53) for reflecting an incident light beam (6).

7. Apparatus according to claim 6,
**characterized in that**
said mirror layer (53) comprises silicon and/or a metal.

8. Apparatus according to anyone of claims 1 - 7,
**characterized by**
means (51) for heating said sensor (2).

9. Apparatus according to anyone of claims 1 - 8,
**characterized by**
means (51) for cooling said sensor (2).

10. Apparatus pparatus according to claim 9,
**characterized in that**
said means for cooling (51) is a Peltier element.

11. Apparatus pparatus according to anyone of claims 1 - 10,
**characterized by**
at least a second light source having a different wavelength than said first light source (1).

12. Apparatus according to anyone of claims 1 - 11,
**characterized by**
a mirror for redirecting said light beam (6) emitted from at least said first light source (1) for scanning said sensor (2).

13. Apparatus according to anyone of claims 1 - 11,
**characterized in that**
the first light source (1) is a plasma light generated by a plasma inside said procesing chamber (5).

14. Apparatus according to anyone of claims 1 - 13,
**characterized by**
a movable shutter (60) for providing a variable aperture for a deposition process on said sensor surface (58).

15. Apparatus according to anyone of claims 1 - 14,
**characterized by**
- a control unit (4) being connected to said first light source (1) and to said detector (3),
- a chopping mechanism attached to said first light source (1) for chopping said light beam (6).

16. Apparatus according to anyone of claims 1 - 15,
**characterized by**
a second sensor (2') mounted at a different position inside said processing chamber (5).

17. Apparatus pparatus according to anyone of claims 1 - 15,
**characterized by**
a moving means (30, 31, 20) for providing a movement of said sensor (2) inside said processing chamber (5).

18. Apparatus according to claim 17,
**characterized in that**
- said moving means (30, 31, 20) acts on said sensor (2) by means of magnetic attraction,
- said moving means (30, 31, 20) is mounted outside said processing chamber (5).

19. Apparatus according to anyone of claims 1 - 18,
**characterized in that**
said sensor (2) comprises at least two surface structures (201 - 204), a first surface structure (201) having a first adsorption sensitivity and a second surface structure (202) having a second adsorption sensitivity.

20. Apparatus according to claim 19,
**characterized in that**
said absorption sensitivity of each of said at least two surface structures (201 - 204) is provided each by a multiple of holes (210) representing a surface roughness supplied with said sensor surface (58).

21. Apparatus according to claim 19,
**characterized in that**
said absorption sensitivity of each of said at least two surface structures (201 - 204) is provided by a surface temperature as supplied by said means for heating (51) or said means for cooling (51).

22. Apparatus according to anyone of claims 1 - 21,
**characterized in that**
said detector (3) is a CCD-camera or one or a multiple of photo diodes.

23. Apparatus according to anyone of claims 1 - 22,
**characterized in that**
said processing chamber (5) is a plasma chamber.

24. Method for monitoring a layer deposition on a sidewall of a plasma chamber (5) using the apparatus according to anyone of claims 1 to 23, comprising the steps:
- irradiating a light beam (6) onto said sensor surface (58) using said first light source (1),
- measuring the intensity of light (9) being emitted by said sensor surface (58) using said detector (3),
- comparing the value of measured intensity with a threshold value representing a thickness value of a layer on the sidewall using said control unit (4, 4'),
- issuing a signal in response to said comparison.

25. Method according to claim 24,
**characterized by**
- irradiating a light beam (6) onto a second sensor surface as a reference,
- measuring the intensity of the light emitted or reflected from said second sensor surface,
- comparing said first and second measured value of light intensity using said control unit (4, 4').

26. Method according to anyone of claims 24 - 25,
**characterized by**
measuring the intensity of light at different wavelengths for obtaining a spectral distribution of reflected light.

27. Method according to anyone of claims 24 - 26,
**characterized by**
moving a mirror for redirecting the beam of light (6) in response to a movement of said sensor (2).

28. Method according to claim 25,
**characterized by**
calculating a time duration of a plasma chamber (5) cleaning interval in response to said signal.

29. Method according to claim 24,
**characterized in that**
said threshold value represents a thickness value, that is obtained from multiple absorption measurements of said sensor (2) being covered with different layer thicknesses, said absorption being related to the tickness of said layer.

## Patentansprüche

1. Vorrichtung zur Überwachung einer Dicke einer auf einer Seitenwand einer Prozesskammer (5) abgelagerten Schicht, umfassend
- mindestens eine erste Lichtquelle (1),
- einen Sensor (2) mit einer Sensoroberfläche (58), wobei der Sensor (2) dafür ausgelegt ist, die Intensität eines Lichtstrahls (6), den der Sensor (2) empfängt und wieder aussendet, zu beeinflussen, wenn er mit einer Schicht aus einem Schichtablagerungsmaterial abgedeckt ist, wobei der Sensor (2) innerhalb der Plasmakammer (5) angeordnet und von der Seitenwand der Prozesskammer (5) verschieden ist,
- einen Detektor (3) zum Detektieren einer Intensität von aus der ersten Lichtquelle (1) stammendem Licht,
- eine mit dem Detektor (3) verbundene Steuereinheit (4) zum Bestimmen der Dicke der an der Seitenwand abgelagerten Schicht aus der Intensitätsmessung,
- wobei die erste Lichtquelle (1), der Sensor (2) und der Detektor (3) so angeordnet sind, daß ein Lichtstrahl (6) auf die Sensoroberfläche (58) gerichtet und durch den Sensor (2) ausgesendetes Licht (9, 9') durch den Detektor (3) empfangen werden kann,
**dadurch gekennzeichnet, daß**
- der Sensor (2) mindestens eine Schicht aus Fluoreszenzmaterial (61) umfaßt,
- der durch die erste Lichtquelle (1) ausgesendete Lichtstrahl (6) eine erste Wellenlänge umfaßt, für die das Schichtablagerungsmaterial im wesentlichen transparent ist und
- das Licht (9'), das von dem Fluoreszenzmaterial (61) wieder ausgesendet wird, eine zweite Wellenlänge umfaßt, für die das Schichtabsorptionsmaterial Intensität absorbiert.

2. Vorrichtung nach Anspruch 1, **dadurch gekennzeichnet, daß**
- die Prozesskammer (5) einen Innenraum umfaßt,
- der Detektor (3) außerhalb des Innenraums positioniert ist,
- die Prozesskammer (5) ein Fenster (7) umfaßt, durch das der Lichtstrahl (6) in Richtung des Detektors (3) aus der Prozesskammer (5) ausrücken kann.

3. Vorrichtung nach Anspruch 1, **dadurch gekennzeichnet, daß**
- die Prozesskammer (5) einen Innenraum umfaßt,
- der Detektor (3) in dem Innenraum positioniert ist.

4. Vorrichtung nach einem der Ansprüche 1-3, **dadurch gekennzeichnet, daß**
der Sensor (2) eine Schutzschicht (54) an der Sensoroberfläche (58) umfaßt, um nicht durch die Ablagerungsverarbeitung beeinflußt zu werden, wobei die Schutzschicht (54) für durch die erste Lichtquelle (1) ausgesendetes Licht transparent ist.

5. Vorrichtung nach Anspruch 4, **dadurch gekennzeichnet, daß**
die Schutzschicht (54) Siliziumdioxid umfaßt.

6. Vorrichtung nach einem der Ansprüche 1-5, **dadurch gekennzeichnet, daß**
der Sensor (2) eine Spiegelschicht (53) zum Reflektieren eines einfallenden Lichtstrahls (6) umfaßt.

7. Vorrichtung nach Anspruch 6, **dadurch gekennzeichnet, daß** die Spiegelschicht (53) Silizium und/oder ein Metall umfaßt.

8. Vorrichtung nach einem der Ansprüche 1-7, **gekennzeichnet durch**
Mittel (51) zum Erwärmen des Sensors (2).

9. Vorrichtung nach einem der Ansprüche 1-8, **gekennzeichnet durch**
Mittel (51) zum Kühlen des Sensors (2).

10. Vorrichtung nach Anspruch 9, **dadurch gekennzeichnet, daß**
das Mittel zum Kühlen (51) ein Peltierelement ist.

11. Vorrichtung nach einem der Ansprüche 1-10, **gekennzeichnet durch**
mindestens eine zweite Lichtquelle mit einer von der ersten Lichtquelle (1) verschiedenen Wellenlänge.

12. Vorrichtung nach einem der Ansprüche 1-11, **gekennzeichnet durch**
einen Spiegel zum Umlenken des von mindestens der ersten Lichtquelle (1) ausgesendeten Lichtstrahls (6) zum Abtasten des Sensors (2).

13. Vorrichtung nach einem der Ansprüche 1-11, **dadurch gekennzeichnet, daß**
die erste Lichtquelle (1) ein durch ein Plasma in der Prozesskammer (5) erzeugtes Plasmalicht ist.

14. Vorrichtung nach einem der Ansprüche 1-13, **gekennzeichnet durch**
eine bewegliche Blende (60) zum Bereitstellen einer variablen Öffnung für einen Ablagerungsprozeß auf der Sensoroberfläche (58).

15. Vorrichtung nach einem der Ansprüche 1-14, **gekennzeichnet durch**
- eine Steuereinheit (4), die mit der ersten Lichtquelle (1) und mit dem Detektor (3) verbunden ist,
- einen an der ersten Lichtquelle (1) angebrachten Chopper-Mechanismus zum Zerteilen des Lichtstrahls (6).

16. Vorrichtung nach einem der Ansprüche 1-15, **gekennzeichnet durch**
einen an einer anderen Position in der Prozesskammer (5) angebrachten zweiten Sensor (2').

17. Vorrichtung nach einem der Ansprüche 1-15, **gekennzeichnet durch**
ein Bewegungsmittel (30, 31, 20) zum Bereitstellen einer Bewegung des Sensors (2) innerhalb der Prozesskammer (5).

18. Vorrichtung nach Anspruch 17, **dadurch gekennzeichnet, daß**
- das Bewegungsmittel (30, 31, 20) mittels magnetischer Anziehung an den Sensor (2) wirkt,
- das Bewegungsmittel (30, 31, 20) außerhalb der Prozesskammer (5) angebracht ist.

19. Vorrichtung nach einem der Ansprüche 1-18, **dadurch gekennzeichnet, daß**
der Sensor (2) mindestens zwei Oberflächenstrukturen (201 - 204) umfaßt, wobei eine erste Oberflächenstruktur (201) eine erste Adsorptionsempfindlichkeit und eine zweite Oberflächenstruktur (202) eine zweite Adsorptionsempfindlichkeit besitzt.

20. Vorrichtung nach Anspruch 19, **dadurch gekennzeichnet, daß**
die Absorptionsempfindlichkeit jeder der beiden Oberflächenstrukturen (201 - 204) jeweils durch eine Vielzahl von Löchern (210) bereitgestellt wird, die eine mit der Sensoroberfläche (58) gelieferte Oberflächenrauhigkeit repräsentiert.

21. Vorrichtung nach Anspruch 19, **dadurch gekennzeichnet, daß**
die Absorptionsempfindlichkeit jeder der mindestens zwei Oberflächenstrukturen (201 - 204) durch eine Oberflächentemperatur bereitgestellt wird, die durch das Mittel zum Erwärmen (51) oder durch das Mittel zum Kühlen (51) geliefert wird.

22. Vorrichtung nach einem der Ansprüche 1-21, **dadurch gekennzeichnet, daß**
es sich bei dem Detektor (3) um eine CCD-Kamera oder um eine oder mehrere Fotodioden handelt.

23. Vorrichtung nach einem der Ansprüche 1-22, **dadurch gekennzeichnet, daß**
die Prozesskammer (5) eine Plasmakammer ist.

24. Verfahren zur Überwachung einer Schichtablagerung auf einer Seitenwand einer Plasmakammer (5) unter Verwendung der Vorrichtung nach einem der Ansprüche 1-23, mit den folgenden Schritten:
- Bestrahlen der Sensoroberfläche (58) mit einem Lichtstrahl (6) unter Verwendung der ersten Lichtquelle (1),
- Messen der Intensität von durch die Sensoroberfläche (58) ausgesendetem Licht (9) unter Verwendung des Detektors (3),
- Vergleichen des Werts der gemessenen Intensität mit einem Schwellenwert, der einen Dickenwert einer Schicht auf der Seitenwand repräsentiert, unter Verwendung der Steuereinheit (4, 4'),
- Ausgeben eines Signals als Reaktion auf den Vergleich.

25. Verfahren nach Anspruch 24, **gekennzeichnet durch**
- Bestrahlen einer zweiten Sensoroberfläche mit einem Lichtstrahl (6) als Referenz,
- Messen der Intensität des von der zweiten Sensoroberfläche ausgesendeten oder reflektierten Lichts,
- Vergleichen des ersten und des zweiten gemessenen Werts der Lichtintensität unter Verwendung der Steuereinheit (4, 4').

26. Verfahren nach einem der Ansprüche 24-25, **gekennzeichnet durch**
Messen der Intensität von Licht bei verschiedenen Wellenlängen zum Erhalten einer Spektralverteilung reflektierten Lichts.

27. Verfahren nach einem der Ansprüche 24-26, **gekennzeichnet durch**
Bewegen eines Spiegels zum Umlenken des Lichtstrahls (6) als Reaktion auf eine Bewegung des Sensors (2).

28. Verfahren nach Anspruch 25, **gekennzeichnet durch**
Berechnen einer Zeitdauer eines Reinigungsintervalls der Plasmakammer (5) als Reaktion auf das Signal.

29. Verfahren nach Anspruch 24, **dadurch gekennzeichnet, daß**
der Schwellenwert einen Dickenwert repräsentiert, der aus mehreren Adsorptionsmessungen des Sensors (2) erhalten wird, der mit verschiedenen Schichtdicken abgedeckt wird, wobei die Absorption mit der Dicke der Schicht zusammenhängt.

## Revendications

1. Dispositif de contrôle de l'épaisseur d'une couche se déposant sur une paroi latérale d'une chambre ( 5 ) de traitement, comprenant
- au moins une première source ( 1 ) lumineuse,
- un capteur ( 2 ) ayant une surface ( 58 ) de capteur, le capteur ( 2 ) étant conçu pour affecter, lorsqu'il est revêtu d'une couche d'une matière de dépôt en couche, l'intensité d'un faisceau ( 6 ) lumineux que le capteur ( 2 ) reçoit et réémet, le capteur ( 2 ) étant placé à l'intérieur de la chambre ( 5 ) à plasma et étant différent de la paroi latérale de la chambre ( 5 ) de traitement,
- un détecteur ( 3 ) de détection d'une intensité de lumière provenant de la première source ( 1 ) lumineuse,
- une unité ( 4 ) de commande, reliée au détecteur ( 3 ) pour déterminer à partir de la mesure d'intensité l'épaisseur de la couche se déposant sur la paroi latérale,
- dans lequel la première source ( 1 ) lumineuse, le capteur ( 2 ) et le détecteur ( 3 ) sont disposés de façon à ce qu'un faisceau ( 6 ) lumineux puisse être dirigé sur la surface ( 58 ) de capteur et de façon à ce que de la lumière ( 9, 9' ) émise par le capteur ( 2 ) puisse être reçue par le détecteur ( 3 ),
**caractérisé en ce que**
- le capteur ( 2 ) comprend au moins une couche de matière ( 61 ) fluorescente,
- le faisceau ( 6 ) de lumière émis par la première source ( 1 ) lumineuse comprend une première longueur d'onde pour laquelle la matière de dépôt en couche est sensiblement transparente et
- **en ce que** la lumière ( 9' ) qui est réémise par la matière ( 61 ) fluorescente comprend une deuxième longueur d'onde pour laquelle la matière de dépôt en couche absorbe l'intensité.

2. Dispositif suivant la revendication 1,
**caractérisé en ce que**
- la chambre ( 5 ) de traitement comprend un espace intérieur,
- le détecteur ( 3 ) est disposé à l'extérieur de l'espace intérieur,
- la chambre ( 5 ) de traitement comprend une fenêtre ( 7 ) par laquelle le faisceau ( 6 ) lumineux peut sortir de la chambre ( 5 ) de traitement et aller vers le détecteur ( 3 ).

3. Dispositif suivant la revendication 1,
**caractérisé en ce que**
- la chambre ( 5 ) de traitement comprend un espace intérieur,
- le détecteur ( 3 ) est placé à l'intérieur de l'espace intérieur.

4. Dispositif suivant l'une quelconque des revendications 1 à 3,
**caractérisé en ce que**
le capteur ( 2 ) comprend une couche ( 54 ) de protection à la surface ( 58 ) du capteur afin de ne pas être affecté par l'opération de dépôt, la couche ( 54 ) de protection étant transparente à la lumière émise par la première source ( 1 ) lumineuse.

5. Dispositif suivant la revendication 4,
**caractérisé en ce que**
la couche ( 54 ) de protection comprend du dioxyde de silicium.

6. Dispositif suivant l'une quelconque des revendications 1 à 5,
**caractérisé en ce que**
le capteur ( 2 ) comprend une couche ( 53 ) formant miroir pour réfléchir un faisceau ( 6 ) lumineux incident.

7. Dispositif suivant la revendication 6,
**caractérisé en ce que**
la couche ( 53 ) formant miroir comprend du silicium et/ou un métal.

8. Dispositif suivant l'une quelconque des revendications 1 à 7,
**caractérisé par**
des moyens ( 51 ) de chauffage du capteur ( 2 ).

9. Dispositif suivant l'une quelconque des revendications 1 à 8,
**caractérisé par** des moyens ( 51 ) de refroidissement du capteur ( 2 ).

10. Dispositif suivant la revendication 9,
**caractérisé en ce que**
les moyens de refroidissement ( 51 ) sont un élément à effet Peltier.

11. Dispositif suivant l'une quelconque des revendications 1 à 10,
**caractérisé par**
au moins une deuxième source lumineuse ayant une longueur d'onde différente de celle de la première source ( 1 ) lumineuse.

12. Dispositif suivant l'une quelconque des revendications 1 à 11,
**caractérisé par**
un miroir pour rediriger le faisceau ( 6 ) lumineux émis par au moins la première source ( 1 ) lumineuse pour balayer le capteur ( 2 ).

13. Dispositif suivant l'une quelconque des revendications 1 à 11,
**caractérisé en ce que**
la première source ( 1 ) lumineuse est une lumière à plasma produite par un plasma à l'intérieur de la chambre ( 5 ) de traitement.

14. Dispositif suivant l'une quelconque des revendications 1 à 13,
**caractérisé par**
un obturateur ( 60 ) mobile pour ménager une ouverture variable pour une opération de dépôt sur la surface ( 58 ) de capteur.

15. Dispositif suivant l'une quelconque des revendications 1 à 14,
**caractérisé par**
- une unité ( 4 ) de commande reliée à la première source ( 1 ) lumineuse et au détecteur ( 3 ),
- un mécanisme de hachage fixé à la première source ( 1 ) lumineuse pour hacher le faisceau ( 6 ) lumineux.

16. Dispositif suivant l'une quelconque des revendications 1 à 15,
**caractérisé par**
un deuxième capteur ( 2' ) monté en une position différente à l'intérieur de la chambre ( 5 ) de traitement.

17. Dispositif suivant l'une quelconque des revendications 1 à 15,
**caractérisé par**
un moyen ( 30, 31, 20 ) mobile pour procurer un mouvement du capteur ( 2 ) à l'intérieur de la chambre ( 5 ) de traitement.

18. Dispositif suivant la revendication 17,
**caractérisé en ce que**
- le moyen ( 30, 31, 20 ) de mouvement agit sur le capteur ( 2 ) au moyen d'une attraction magnétique,
- le moyen ( 30, 31, 20 ) de mouvement est monté à l'extérieur de la chambre ( 5 ) de traitement.

19. Dispositif suivant l'une quelconque des revendications 1 à 18,
**caractérisé en ce que**
le capteur ( 2 ) comprend au moins deux structures ( 201 à 204 ) de surface, une première structure ( 201 ) de surface ayant une première sensibilité d'adsorption et une deuxième structure ( 202 ) de surface ayant une deuxième sensibilité d'adsorption.

20. Dispositif suivant la revendication 19,
**caractérisé en ce que**
la sensibilité d'adsorption de chacune des au moins deux structures ( 201 à 204 ) de surface est procurée par une multiplicité de trous ( 210 ) représentant une rugosité de surface donnée par la surface ( 58 ) de capteur.

21. Dispositif suivant la revendication 19,
**caractérisé en ce que**
la sensibilité d'adsorption de chacune des au moins deux structures ( 201 à 204 ) de surface est procurée par une température de surface tel que donnée par les moyens de chauffage ( 51 ) ou par les moyens de refroidissement ( 51 ).

22. Dispositif suivant l'une quelconque des revendications 1 à 21,
**caractérisé en ce que**
le détecteur ( 3 ) est une caméra CCD ou une photodiode ou plusieurs photodiodes.

23. Dispositif suivant l'une quelconque des revendications 1 à 22,
**caractérisé en ce que**
la chambre ( 5 ) de traitement est une chambre à plasma.

24. Procédé de contrôle de dépôt d'une couche sur une paroi latérale d'une chambre ( 5 ) à plasma en utilisant le dispositif suivant l'une quelconque des revendications 1 à 23, dans lequel :
- on envoie un faisceau ( 6 ) lumineux sur la surface ( 58 ) de capteur en utilisant la première source ( 1 ) lumineuse,
- on mesure l'intensité de la lumière ( 9 ) émise par la surface ( 58 ) de capteur en utilisant le détecteur ( 3 ) et
- on compare la valeur de l'intensité mesurée à une valeur de seuil représentant une valeur d'épaisseur d'une couche sur la paroi latérale en utilisant l'unité ( 4, 4' ) de commande,
- on émet un signal en réaction à la comparaison.

25. Procédé suivant la revendication 24,
**caractérisé en ce que**
- on envoie un faisceau ( 6 ) lumineux sur une deuxième surface de capteur en tant que témoin,
- on mesure l'intensité de la lumière émise ou réfléchie par la deuxième surface de capteur,
- on compare la première et la deuxième valeur mesurées de l'intensité de la lumière en utilisant l'unité ( 4, 4' ) de commande.

26. Procédé suivant l'une quelconque des revendications 24 ou 25,
**caractérisé en ce que**
l'on mesure l'intensité de la lumière à des longueurs d'onde différentes pour obtenir une répartition spectrale de la lumière réfléchie.

27. Procédé suivant l'une quelconque des revendications 24 à 26,
**caractérisé en ce que**
l'on déplace un miroir pour rediriger le faisceau de lumière ( 6 ) en réaction à un mouvement du capteur ( 2 ).

28. Procédé suivant la revendication 25,
**caractérisé en ce que**
l'on calcule une durée de l'intervalle de nettoyage d'une chambre ( 5 ) plasma en réaction audit signal.

29. Procédé suivant la revendication 24,
**caractérisé en ce que**
la valeur de seuil représente une valeur de pression, qui est obtenue à partir de multiples mesures d'absorption du capteur ( 2 ) revêtu d'épaisseurs de couche différentes, l'absorption étant reliée à l'épaisseur de la couche.
